# EUROPEAN PATENT APPLICATION

(11) **EP 4 722 409 A1**
(43) Date of publication of application: **08.04.2026**
(21) Application number: 23938630.3
(22) Date of filing: 21.11.2023
(51) Int. Cl.: C23C 14/56, C23C 14/34, H01B 12/00

(54) **DEPOSITION APPARATUS FOR SUPERCONDUCTOR**

(30) Priority: 24.05.2023 KR 20230067031
(71) Applicant: Maru L&C Co., Ltd., Daegu 42702 (KR)
(72) Inventor: KIM, Dong Jin, Daegu 42702 (KR); CHOI, Man Ho, Daegu 42828 (KR)
(74) Representative: Zacco Sweden AB
(86) International application number: PCT/KR2023/018748
(87) International publication number: WO 2024/242260

(57) **Abstract**

The present invention relates to a deposition apparatus for a superconductor, the apparatus comprising: a withdrawal unit around which a wire rod unit is wound; a plurality of chambers through which the wire rod unit withdrawn from the withdrawal unit passes and which are spaced apart from one another so as to perform individual deposition processes; and a retraction unit which retracts the wire rod unit having passed through the chambers, wherein the wire rod unit is withdrawn from the withdrawal unit and then undergoes deposition while sequentially passing through the plurality of chambers, disposed between the withdrawal unit and the retraction unit, before retracting into the retraction unit. The wire rod unit is wound around each chamber unit one or more times such that the deposition time for the wire rod unit, in the limited inner spaces of the chamber units, is extended and thus the size of the entire facility can be reduced.

## Description

### [Technical Field]

The present invention relates to a deposition apparatus for a superconductor, and more particularly, to a deposition apparatus for a superconductor in which a deposition process is performed in each comparted chamber, thereby rapidly performing the maintenance of each chamber and improving a deposition speed.

### [Background Art]

In general, superconductivity refers to a phenomenon in which electrical resistance of any material disappears under certain conditions, and a temperature at which superconductivity occurs may vary according to types of metals and compounds.

According to a low temperature critical temperature, superconductors are classified into low-temperature superconductors (liquid helium temperature) and high-temperature superconductors (liquid nitrogen temperature). A high-temperature superconductor (HTS) includes a substrate, an intermediate layer (buffer layer), a superconducting layer, and a protective layer. In this case, the substrate may be a metal body, and the buffer layer may include 2 to 5 layers according to the characteristics.

The substrate mainly includes a Hastelloy or stainless steel material, and the buffer layer deposited on the substrate includes a diffusion barrier layer, a seed layer, an ion-beam-assisted deposition (IBAD) layer, a homoepitaxial layer, and a strain-matching layer. A superconducting layer is provided to cover the buffer layer, and a silver protective layer is provided to cover the superconducting layer.

Meanwhile, conventionally, a buffer layer is deposited while a superconducting wire passes through a chamber, but a moving speed of a wire is decreased such that deposition is performed at a set thickness, and thus there are problems in that productivity is lowered, and the entire process is stopped for maintenance of some deposition equipment. Therefore, there is a need to solve such problems.

The background art of the present invention is disclosed in Korean Patent Publication No. 10-2012-0034123 (published on April 9, 2012, title of the invention: Organic metal chemical vapor deposition method and device for producing multilayer high-temperature superconducting coated-tape).

### [Disclosure]

### [Technical Problem]

The present invention has been made to improve the above problems and is directed to providing a deposition apparatus for a superconductor in which a deposition process is performed in each comparted chamber, thereby rapidly performing the maintenance of each chamber and improving a deposition speed.

### [Technical Solution]

A deposition apparatus for a superconductor according to the present invention includes a withdrawal unit on which a wire portion is wound, a plurality of chambers configured to allow the wire portion discharged from the withdrawal unit to pass therethrough and spaced apart from each other to perform individual deposition processes, and a collection unit configured to collect the wire portion that has passed through the chamber.

Each of the plurality of chambers may guide the wire portion to be wound one or more times and moved so that deposition is performed.

The wire portion, which is wound on the plurality of chambers and moved, may be wound in one direction.

The wire portion, which is wound on the plurality of chambers and moved, may be wound alternately in one direction and another direction.

The chamber may include a chamber case configured to allow the wire portion to pass therethrough, a chamber roller portion embedded in the chamber case and configured to guide the wire portion to be wound one or more times and moved, and a chamber deposition portion embedded in the chamber case and configured to perform deposition on the wire portion.

The chamber case may include a case space portion which forms a deposition space and is openable/closable, a case inlet which is formed at one side of the case space portion and through which the wire portion is introduced, and a case outlet which is formed at the other side of the case space portion and through which the wire portion is discharged.

The chamber roller portion may include a roller inlet guide portion configured to guide the wire portion introduced into the chamber case, a roller outlet guide portion configured to guide the wire portion discharged from the chamber case, and a roller process portion disposed between the roller inlet guide portion and the roller outlet guide portion and configured to guide the wire portion to be wound one or more times and moved.

The deposition apparatus according to the present invention may further include a connection portion disposed between the plurality of chambers to cover the wire portion.

The connection portion may include a connection duct portion disposed between the plurality of chambers and configured to connect the chambers adjacent to each other to allow the wire portion to pass therethrough, a connection discharge portion formed in the connection duct portion and configured to discharge air inside the connection duct portion to the outside, and a connection delay portion which is formed inside the connection duct portion, allows the wire portion to pass therethrough, and delays movement of a deposition material and internal gas between the adjacent chambers.

### [Advantageous Effects]

According to a deposition apparatus for a superconductor according to the present invention, a wire portion drawn from a withdrawal unit may be collected by a collection unit, and while the wire portion passes through a plurality of chambers disposed between the withdrawal unit and the collection unit, deposition may be performed. In this case, since the wire portion is wound on the chamber one or more times, a deposition time for the wire portion in a limited internal space of the chamber increases, thereby reducing the overall size of equipment.

### [Description of Drawings]

FIG. 1 is a schematic view illustrating a deposition apparatus for a superconductor according to one embodiment of the present invention.
FIG. 2 is a schematic plan view illustrating a state in which a wire portion is continuously wound on chambers in a right direction according to one embodiment of the present invention.
FIG. 3 is a schematic plan view illustrating a state in which the wire portion is continuously wound on the chambers in a left direction according to one embodiment of the present invention.
FIG. 4 is a schematic plan view illustrating a state in which the wire portion is continuously wound on the chambers alternately in right and left directions according to one embodiment of the present invention.
FIG. 5 is a schematic view illustrating the chamber according to one embodiment of the present invention.
FIG. 6 is a schematic view illustrating a chamber case according to one embodiment of the present invention.
FIG. 7 is a schematic view illustrating a chamber roller portion according to one embodiment of the present invention.
FIG. 8 is a schematic view illustrating a connection portion according to one embodiment of the present invention.
FIG. 9 shows schematic views illustrating a connection delay portion according to a first embodiment of the present invention.
FIG. 10 is a schematic view illustrating a connection delay portion according to a second embodiment of the present invention.
FIG. 11 is a schematic view illustrating a state in which frequency interference is prevented by the connection portion according to one embodiment of the present invention.

### [Modes of the Invention]

Hereinafter, embodiments of a deposition apparatus for a superconductor according to the present invention will be described with reference to the accompanying drawings. The drawings are not necessarily to scale, and in some instances, proportions may have been exaggerated in order to clearly illustrate features of the embodiments. Further, terms to be described below are terms defined in consideration of functions in the present invention and thus may vary according to intentions or customs of users and operators. Accordingly, the definitions of such terms should be made based on the content throughout the specification.

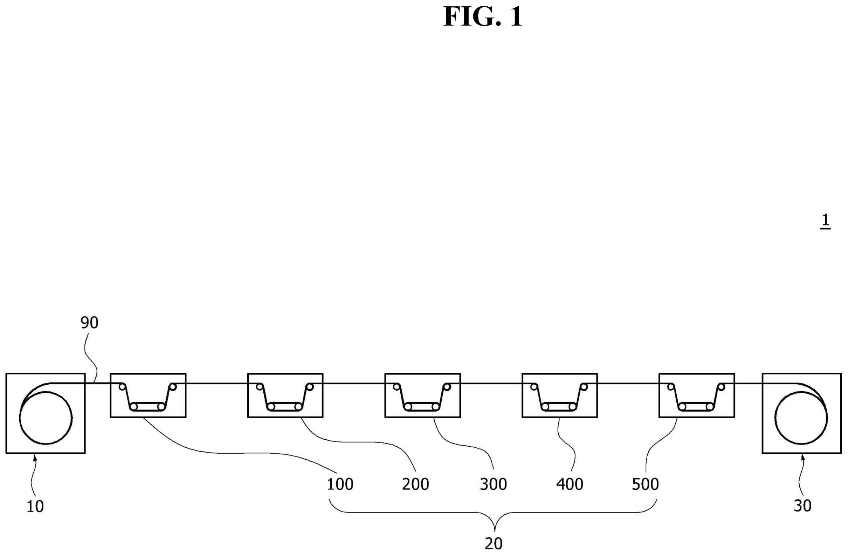

FIG. 1 is a schematic view illustrating a deposition apparatus for a superconductor according to one embodiment of the present invention. Referring to FIG. 1, a deposition apparatus 1 for a superconductor according to one embodiment of the present invention may include a withdrawal unit 10, a chamber 20, and a collection unit 30.

A wire portion 90 is wound on the withdrawal unit 10. As an example, a metal film is used as the wire portion 90, and the wire portion 90 may be unwound by rotating at a set speed after being wound on the withdrawal unit 10.

A plurality of chambers 20 may be spaced apart from each other to allow the wire portion 90 discharged from the withdrawal unit 10 to pass therethrough and allow individual deposition processes to be performed. As an example, the plurality of chambers 20 may be arranged in a line, and while the wire portion 90 sequentially passes through the chambers 90, buffer layer deposition may be performed.

The collection unit 30 may collect the wire portion 90 that has passed through the chamber 20. As an example, while a roll rotates, the collection unit 30 may wind the wire portion 90 on which a deposition is completed.

In this case, each chamber 20 may guide the wire portion 90 to be wound one or more times and moved so that deposition is performed.

When the wire portions 90 are wound without overlapping each other, a deposition time may be secured during a time for which the wire portion 90 is wound several times while moving. Thus, even when a lateral length of the chamber 20 is short, a sufficient deposition space can be secured.

The chambers 20 may include a first chamber 100, a second chamber 200, a third chamber 300, a fourth chamber 400, and a fifth chamber 500 according to deposition types.

The first chamber 100 may deposit a first layer on the wire portion 90. The first layer may be a diffusion barrier layer that prevents a nickel or chromium metal from being diffused in one direction on a deposition surface of the wire portion 90. The first chamber 100 may perform deposition using a sputtering method. A plurality of first chambers 100 may be consecutively arranged as needed.

The second chamber 200 may deposit a second layer on the wire portion 90 on which the first layer is deposited. The second layer may be a seed layer that provides a surface for nucleation to a third layer. The second chamber 200 may perform deposition using a sputtering method, and yttrium oxide may be used as a deposition material. A plurality of second chambers 200 may be consecutively arranged as needed.

The third chamber 300 may deposit the third layer on the wire portion 90 on which the second layer is deposited. Since a thin film may be formed according to a crystal orientation, the third layer may be an ion-beam-assisted deposition (IBAD) layer that provides a two-axis orientation to a superconducting layer. The third chamber 300 may perform deposition using an IBAD method, and magnesium oxide may be used as a deposition material. A plurality of third chambers 300 may be consecutively arranged as needed.

The fourth chamber 400 may deposit a fourth layer on the wire portion 90 on which the third layer is deposited. The fourth layer may be a homo-epi layer that improves the two-axis orientation of the third layer.

The fourth chamber 400 may perform deposition using an E-beam evaporation method, and magnesium oxide may be used as a deposition material. A plurality of fourth chambers 400 may be consecutively arranged as needed.

The fifth chamber 500 may deposit a fifth layer on the wire portion 90 on which the fourth layer is deposited. The fifth layer may be a strain-matching layer that reduces the mismatch between the superconducting layer and the fourth layer.

The fifth chamber 500 may perform deposition using a sputtering method, and lanthanum manganese oxide may be used as a deposition material. A plurality of fifth chambers 500 may be consecutively arranged as needed.

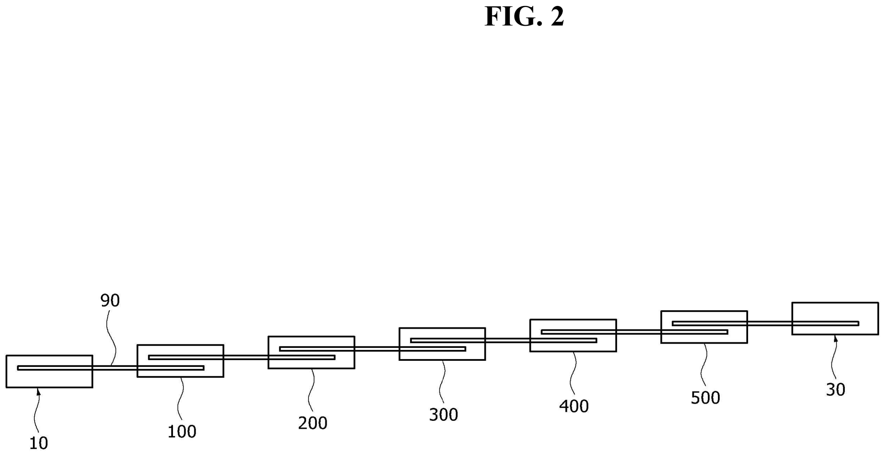

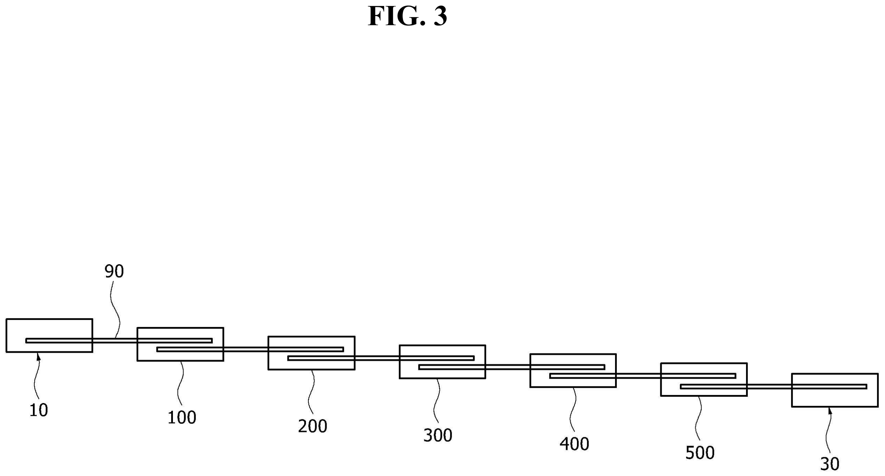

FIG. 2 is a schematic plan view illustrating a state in which the wire portion is continuously wound on the chambers in a right direction according to one embodiment of the present invention. FIG. 3 is a schematic plan view illustrating a state in which the wire portion is continuously wound on the chambers in a left direction according to one embodiment of the present invention. Referring to FIGS. 2 and 3, the wire portion 90 that is wound on the plurality of chambers 20 and moved may be wound in one direction.

That is, when the movement of the wire portion 90 is viewed from above, the wire portion 90 may be continuously wound on the chambers 20 in the right direction (see FIG. 2). Otherwise, when the movement of the wire portion 90 is viewed from above, the wire portion 90 may be continuously wound on the chambers 20 in the left direction (see FIG. 3).

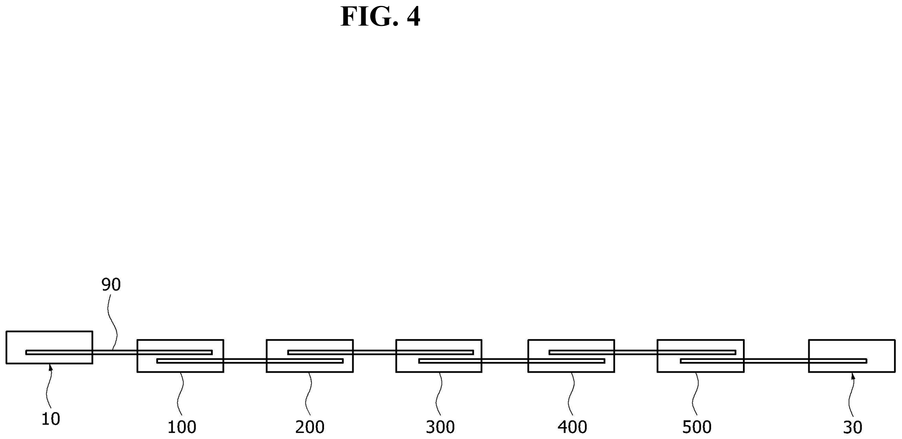

FIG. 4 is a schematic plan view illustrating a state in which the wire portion is continuously wound on the chambers alternately in right and left directions according to one embodiment of the present invention. Referring to FIG. 4, the wire portion 90 that is wound on the plurality of chambers 20 and moved may be wound alternately in one direction and the other direction.

That is, when the movement of the wire portion 90 is viewed from above, a process in which the wire portion 90 is wound on one chamber 20 in the right direction and then wound on an adjacent chamber 20 in the left direction may be repeated.

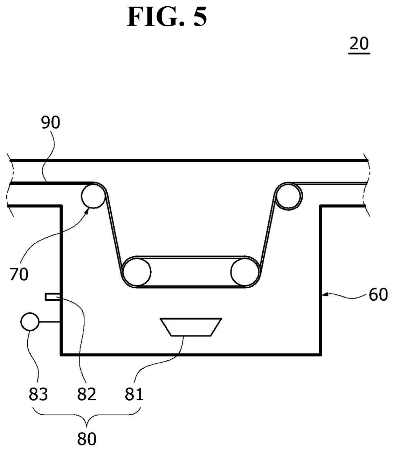

FIG. 5 is a schematic view illustrating the chamber according to one embodiment of the present invention. Referring to FIG. 5, the chamber 20 according to one embodiment of the present invention may include a chamber case 60, a chamber roller portion 70, and a chamber deposition portion 80. Such components may be provided in each chamber 20.

The chamber case 60 may allow the wire portion 90 to pass therethrough. As an example, a space for performing a deposition process may be formed inside each chamber case 60, and holes through which the wire portion 90 passes may be formed at both sides thereof.

The chamber roller portion 70 may be embedded in the chamber case 60 and may guide the wire portion 90 to be wound thereon one or more times and moved. As an example, a deposition process may be performed in a state in which the wire portion 90 is wound in an axial direction of the chamber roller portion 70 and a surface thereof is exposed.

The chamber deposition portion 80 may be embedded in the chamber case 60 and may perform deposition on the wire portion 90. As an example, the chamber deposition portion 80 may include a deposition material portion 81 embedded in the chamber case 60, a deposition gas portion 82 that supplies gas to the chamber case 60, and a deposition power supply 83 that supplies power to the chamber case 60. The deposition power supply 83 may supply a high frequency or DC current.

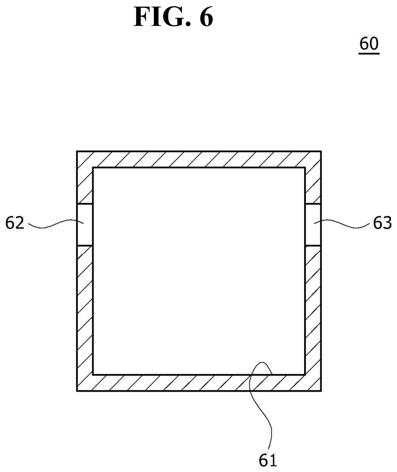

FIG. 6 is a schematic view illustrating the chamber case according to one embodiment of the present invention. Referring to FIG. 6, the chamber case 60 according to one embodiment of the present invention may include a case space portion 61, a case inlet 62, and a case outlet 63.

The case space portion 61 may form a deposition space and may be opened or closed. As an example, the case space portion 61 may be provided as a pair of upper and lower or left and right spaces portions, and the pair of upper and lower or left and right spaces portions may be in close contact with each other to maintain an airtight state. When the pair of upper and lower or left and right spaces portions are separated from each other, internal equipment maintenance work may be performed.

The case inlet 62 may be formed at one side of the case space portion 61, and the wire portion 90 may be introduced thereinto. The case inlet 62 may be formed in one side surface of the case space portion 61 and may have a hole or duct shape to allow the wire portion 90 to pass therethrough.

The case outlet 63 may be formed at the other side of the case space portion 61, and the wire portion 90 on which deposition is completed in the case space portion 61 may be discharged therethrough. The case outlet 63 may be formed in the other side surface of the case space portion 61 and may have a hole or duct shape to allow the wire portion 90 to pass therethrough.

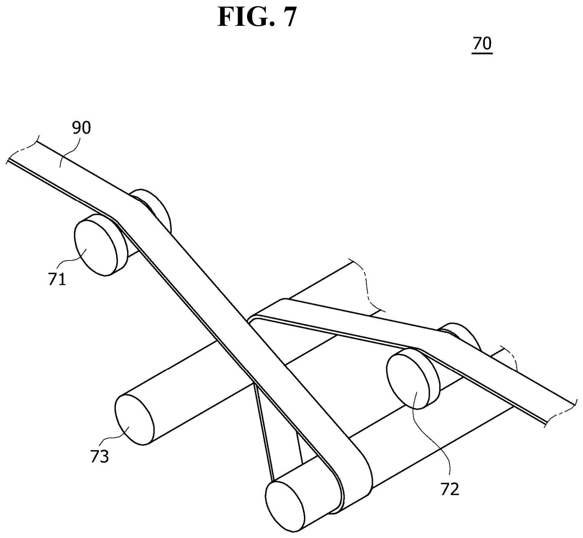

FIG. 7 is a schematic view illustrating the chamber roller portion according to one embodiment of the present invention. Referring to FIG. 7, the chamber roller portion 70 according to one embodiment of the present invention may include a roller inlet guide portion 71, a roller outlet guide portion 72, and a roller process portion 73.

The roller inlet guide portion 71 may guide the wire portion 90 introduced into the chamber case 60. The roller inlet guide portion 71 may be rotatably mounted in the case space portion 61 and may be disposed close to the case inlet 62. The roller inlet guide portion 71 may move up, down, left, and right based on a rotation axis, thereby adjusting the position of the wire portion 90.

The roller outlet guide portion 72 may guide the wire portion 90 discharged from the chamber case 60. The roller outlet guide portion 72 may be rotatably mounted in the case space portion 61 and may be disposed close to the case outlet 63. The roller outlet guide portion 72 may move up, down, left, and right based on a rotation axis, thereby adjusting the position of the wire portion 90.

The roller process portion 73 may be disposed between the roller inlet guide portion 71 and the roller outlet guide portion 72 and may guide the wire portion 90 to be wound one or more times and moved. The roller process portion 73 may include two or more rollers disposed apart from each other. The wire portion 90 may be wound on the roller process portion 73 such that portions thereof do not overlap each other, and thus deposition may be performed on an exposed surface.

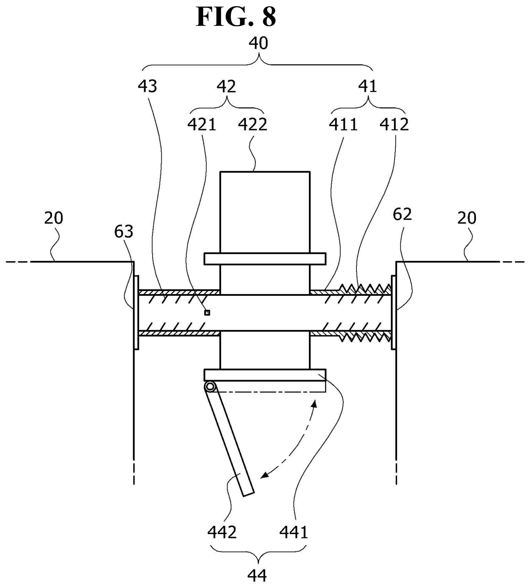

FIG. 8 is a schematic view illustrating a connection portion according to one embodiment of the present invention. Referring to FIG. 8, the apparatus 1 for depositing a superconductor according to one embodiment of the present invention may further include a connection portion 40.

The connection portion 40 may be positioned between the plurality of chambers 20 to surround the wire portion 90 and maintain a process environment of each of the plurality of chambers 20.

The connection portion 40 may be connected to the case inlet 62 formed in any one chamber 20 and the case outlet 63 formed in another chamber 20. Both end portions of the connection portion 40 may be assembled to the chamber 20. In this case, an assembly portion may be sealed to block the inflow of external gas.

More specifically, the connection portion 40 may include a connection duct portion 41, a connection discharge portion 42, and a connection delay portion 43.

The connection duct portion 41 may be disposed between the chambers 20 and may connect adjacent chambers 20 to allow the wire portion 90 to pass therethrough.

Both end portions of the connection duct portion 41 may communicate with the case inlet 62 formed in any one chamber 20 and the case outlet 63 formed in another chamber 20. The connection duct portion 41 may connect the chamber 20 and the withdrawal unit 10 and connect the chamber 20 and the collection unit 30.

The connection duct portion 41 may include a first duct portion 411 made of a rigid body, and a second duct portion 412 connected to an end portion of the first duct portion 411 and having a corrugated shape to have an adjustable length.

Thus, after each chamber 20 is disposed, the first duct portion 411 may be connected to any one chamber 20, and the length of the contracted second duct portion 412 may be increased to be connected to another chamber 20.

The connection duct portion 41 may move up, down, left, and right according to a movement path of the wire portion 90. As an example, flanges formed at both end portions of the connection duct portion 41 may face the chambers 20, and a fastening hole for bolt coupling may be formed to be greater than a size of a bolt so that the flange may move up, down, left, and right based on the bolt.

A washer mounted on the bolt that fixes the flange to the chamber 20 may be formed to be greater than the fastening hole to press the flange. A sealing member may be disposed between the connection duct portion 41 and the chamber 20.

The connection discharge portion 42 may be formed in the connection duct portion 41 and may discharge air inside the connection duct portion 41 to the outside.

The connection discharge portion 42 may include a discharge detector 421 that detects pressure, materials, or the like inside the connection duct portion 41, and a discharge pump portion 422 that receives a detection signal from the discharge detector 421 and discharges air inside the connection duct portion 41 to the outside to maintain a vacuum state in the connection duct portion 41.

The connection delay portion 43 may be formed inside the connection duct portion 41, may allow the wire portion 90 to pass therethrough, may block the inflow of a deposition material between adjacent chambers 20, and may delay the movement of internal gas.

The connection delay portion 43 may delay a deposition material formed in any one chamber 20 from moving to another chamber 20 through the connection duct portion 41. In this way, when a movement speed of a deposition material and internal gas due to a pressure difference is significantly reduced, the capacity and operating time of the discharge pump portion 422 may be reduced.

The connection portion 40 may further include a connection opening/closing portion 44. The connection opening/closing portion 44 may be formed on the connection duct portion 41 and may be opened/closed for work. That is, the connection opening/closing portion 44 may be added to improve the installation workability of the initial wire portion 90 in a system.

The connection opening/closing portion 44 may include an opening/closing pipe 441 that communicates with the first duct portion 411, and an opening/closing door 442 that opens/closes the opening/closing pipe 441.

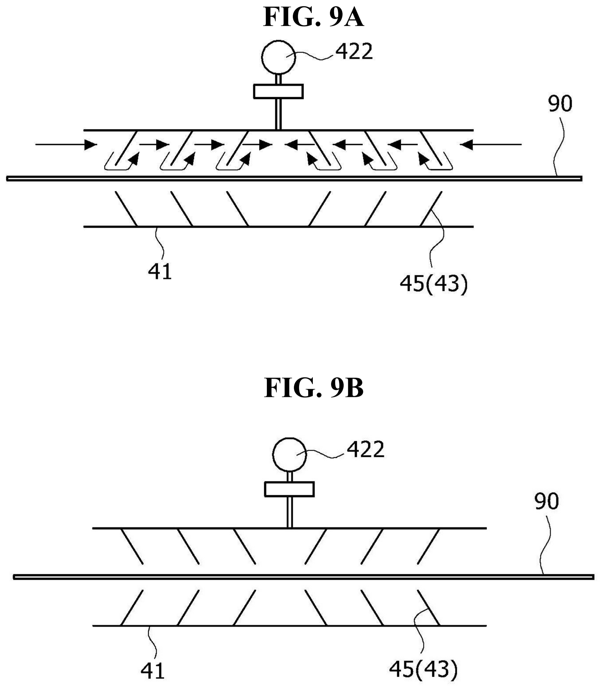

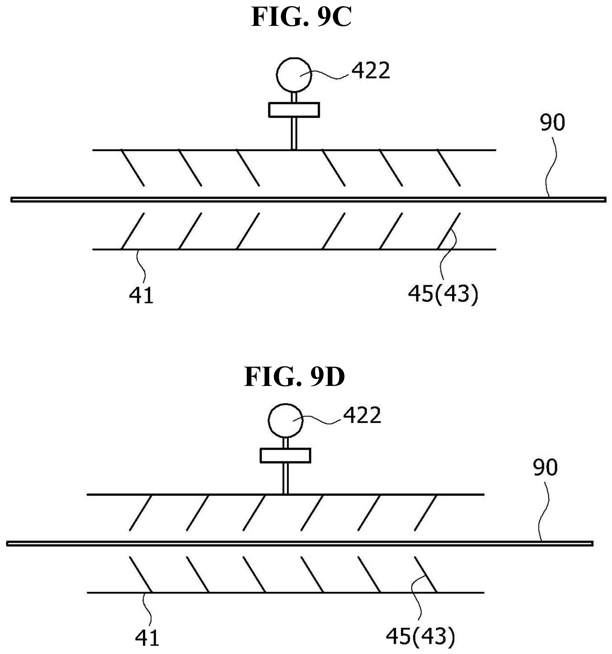

FIG. 9 shows schematic views illustrating the connection delay portion according to a first embodiment of the present invention. Referring to FIG. 9, the connection delay portion 43 according to the first embodiment may include a delay protrusion 45.

A plurality of delay protrusions 45 may extend inward from an inner wall of the connection duct portion 41. The delay protrusions 45 may protrude from an upper portion and a lower portion of the connection duct portion 41 toward the wire portion 90. The plurality of delay protrusions 45 may be disposed apart from each other in a longitudinal direction of the connection duct portion 41 and may be disposed to be inclined to reduce a movement speed of a deposition material.

As an example, the discharge pump portion 422 may be positioned at a central portion of the connection duct portion 41, the delay protrusion 45 may be disposed to be inclined leftward at a left side of the discharge pump portion 422, and the delay protrusion 45 may be disposed to be inclined rightward at a right side of the discharge pump portion 422 (see FIG. 9A).

The discharge pump portion 422 may be positioned at the central portion of the connection duct portion 41, the delay protrusion 45 may be disposed to be inclined rightward at the left side of the discharge pump portion 422, and the delay protrusion 45 may be disposed to be inclined leftward at the right side of the discharge pump portion 422 (see FIG. 9B).

The delay protrusion 45 may be disposed to be inclined rightward in the longitudinal direction of the connection duct portion 41 (see FIG. 9C), or the delay protrusion 45 may be disposed to be inclined leftward in the longitudinal direction of the connection duct portion 41 (see FIG. 9D).

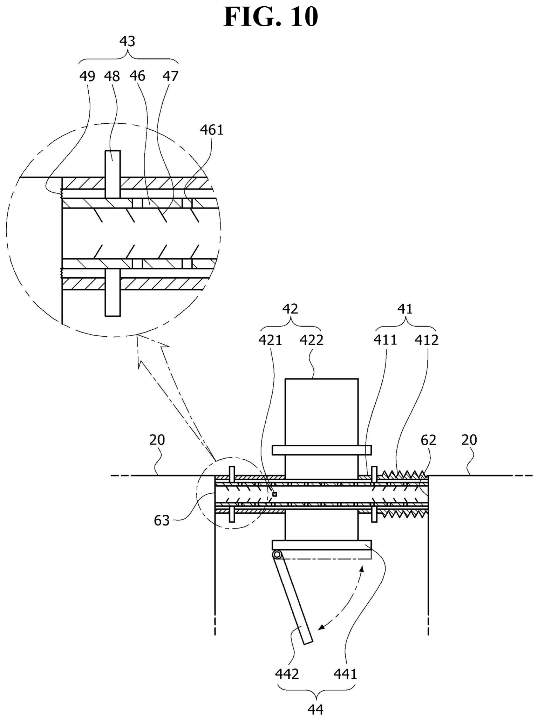

FIG. 10 is a schematic view illustrating the connection delay portion according to a second embodiment of the present invention. Referring to FIG. 10, the connection delay portion 43 according to the second embodiment of the present invention may include a delay pipe 46, a delay baffle 47, and a delay controller 48.

The delay pipe 46 may be embedded in the connection duct portion 41, may allow the wire portion 90 to pass therethrough, and may have a plurality of opening holes 461 formed therein. The delay pipe 46 may be assembled inside the connection duct portion 41 or may be disposed apart from the inside of the connection duct portion 41.

A plurality of delay baffles 47 may protrude inward from the delay pipe 46. As an example, the delay baffle 47 may have a shape corresponding to the delay protrusion 45 of FIG. 9.

The delay controller 48 may be mounted on the connection duct portion 41, and a mounting position of the delay pipe 46 may be adjusted to correspond to a position of the wire portion 90. The delay controller 48 may be disposed at each of left and right sides and upper and lower sides of the delay pipe 46. The delay controller 48 itself may move forward and backward or change a length thereof to push or pull the delay pipe 46, thereby moving the delay pipe 46 in up, down, left, and right directions.

An end portion of the delay controller 48 may be connected to the delay pipe 46 and coupled to the connection duct portion 41, and a position of the delay controller 48 itself may be shifted to adjust a position of the delay pipe 46. The delay controller 48 may be disposed between the connection duct portion 41 and the delay pipe 46, and a length of the delay controller 48 may be increased or decreased to adjust the position of the delay pipe 46.

Meanwhile, a delay sealing portion 49 may be provided to prevent a deposition material from flowing in between the connection duct portion 41 and the delay pipe 46. The delay sealing portion 49 may cover a space between both end portions of the delay pipe 46 and the connection duct portion 41.

A shape of the delay sealing portion 49 may be deformed to maintain a sealing state during a position adjustment process of the delay pipe 46. As an example, the delay sealing portion 49 may have a corrugated curtain shape.

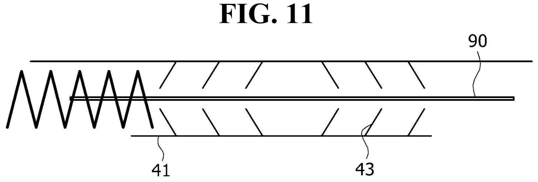

FIG. 11 is a schematic view illustrating a state in which frequency interference is prevented by the connection portion according to one embodiment of the present invention. Referring to FIG. 11, the connection delay portion 43 may prevent frequency interference according to the use of high-frequency power.

That is, when a high frequency supplied by the deposition power supply 83 in FIG. 5 moves to an adjacent chamber 20 through the connection duct portion 41, electrical interference may occur. When the connection delay portion 43 protrudes to the inside of the connection duct portion 41, a radio frequency (RF) frequency may be blocked by the connection delay portion 43 to block movement to the adjacent chamber 20.

The operation of the deposition apparatus for a superconductor according to one embodiment of the present invention having the above-described configuration will now be described.

The wire portion 90 wound on the withdrawal unit 10 sequentially passes through the plurality of chambers 20 and then is wound on the collection unit 30. In this case, superconductor buffer layers are sequentially deposited while the wire portion 90 passes through each chamber 20.

Since the wire portion 90 is wound on each chamber 20 one or more times and moved, a deposition time can be increased in a limited space inside the chamber 20, and the overall length and volume of equipment can be reduced. In addition, according to an installation environment, a direction in which the wire portion 90 is wound on the chamber 20 can be changed in various ways.

The connection portion 40 may be disposed between the chambers 20, and the connection delay portion 43 formed in the connection portion 40 may delay a deposition material formed in each chamber 20 from moving to an adjacent chamber 20 due to a pressure difference.

When the connection discharge portion 42 discharges air inside the connection duct portion 41 to the outside in a state in which the movement of a deposition material is delayed by the connection delay portion 43, a stable deposition environment of each chamber 20 can be maintained.

According to one embodiment of the present invention, in the deposition apparatus for a superconductor, the wire portion 90 drawn from the withdrawal unit 10 may be collected by the collection unit 30, and while the wire portion 90 sequentially passes through the plurality of chambers 20 disposed between the withdrawal unit 10 and the collection unit 30, deposition may be performed.

In this case, since the wire portion 90 is wound on the chamber 20 one or more times, a deposition time for the wire portion 90 in a limited internal space of the chamber 20 increases, thereby reducing the overall size of equipment.

The present invention has been described with reference to embodiments shown in the drawings, but this is merely illustrative, and those skilled in the art will understand that various modifications and other equivalent embodiments are possible therefrom. Therefore, the true technical protection scope of the present invention should be defined by the appended claims.

## Claims

1. A deposition apparatus for a superconductor, comprising:
a withdrawal unit on which a wire portion is wound;
a plurality of chambers configured to allow the wire portion discharged from the withdrawal unit to pass therethrough and spaced apart from each other to perform individual deposition processes; and
a collection unit configured to collect the wire portion that has passed through the chamber.

2. The deposition apparatus of claim 1, wherein each of the plurality of chambers guides the wire portion to be wound one or more times and moved so that deposition is performed.

3. The deposition apparatus of claim 2, wherein the wire portion, which is wound on the plurality of chambers and moved, is wound in one direction.

4. The deposition apparatus of claim 2, wherein the wire portion, which is wound on the plurality of chambers and moved, is wound alternately in one direction and another direction.

5. The deposition apparatus of claim 1, wherein the chamber includes:
a chamber case configured to allow the wire portion to pass therethrough;
a chamber roller portion embedded in the chamber case and configured to guide the wire portion to be wound one or more times and moved; and
a chamber deposition portion embedded in the chamber case and configured to perform deposition on the wire portion.

6. The deposition apparatus of claim 5, wherein the chamber case includes:
a case space portion which forms a deposition space and is openable/closable;
a case inlet which is formed at one side of the case space portion and through which the wire portion is introduced; and
a case outlet which is formed at the other side of the case space portion and through which the wire portion is discharged.

7. The deposition apparatus of claim 5, wherein the chamber roller portion includes:
a roller inlet guide portion configured to guide the wire portion introduced into the chamber case;
a roller outlet guide portion configured to guide the wire portion discharged from the chamber case; and
a roller process portion disposed between the roller inlet guide portion and the roller outlet guide portion and configured to guide the wire portion to be wound one or more times and moved.

8. The deposition apparatus of claim 1, further comprising a connection portion disposed between the plurality of chambers to cover the wire portion.

9. The deposition apparatus of claim 8, wherein the connection portion includes:
a connection duct portion disposed between the plurality of chambers and configured to connect the chambers adjacent to each other to allow the wire portion to pass therethrough;
a connection discharge portion formed in the connection duct portion and configured to discharge air inside the connection duct portion to the outside; and
a connection delay portion which is formed inside the connection duct portion, allows the wire portion to pass therethrough, and delays movement of a deposition material and internal gas between the adjacent chambers.
